# EUROPÄISCHE PATENTSCHRIFT

(11) **EP 3 510 470 B1**
(45) Veröffentlichungstag und Bekanntmachung des Hinweises auf die Patenterteilung: **27.09.2023**
(21) Anmeldenummer: 17748751.9
(22) Anmeldetag: 03.08.2017
(51) Int. Cl.: G06F 3/01, H02N 2/04, H10N 30/50

(54) **VORRICHTUNG ZUR ERZEUGUNG EINER HAPTISCHEN RÜCKMELDUNG**
DEVICE FOR PRODUCING HAPTIC FEEDBACK
DISPOSITIF DE GÉNÉRATION D'UN RETOUR HAPTIQUE

(30) Priorität: 07.09.2016 DE 102016116763
(43) Veröffentlichungstag der Anmeldung: 17.07.2019
(73) Patentinhaber: TDK Electronics AG, 81671 München (DE)
(72) Erfinder: RINNER, Franz, 8530 Deutschlandsberg (AT); KASTL, Harald, 8524 Bad Gams (AT)
(74) Vertreter: Epping - Hermann - Fischer
(86) Internationale Anmeldenummer: PCT/EP2017/069708
(87) Internationale Veröffentlichungsnummer: WO 2018/046201

(56) Entgegenhaltungen:
- EP-A1- 0 902 488
- WO-A1-2014/096565
- WO-A1-2016/067831
- WO-A1-2017/060011
- CN-A- 102 394 270
- DE-T2- 69 635 870
- US-A1- 2011 193 824
- US-A1- 2015 309 576
- US-B1- 6 465 936

## Beschreibung

Die Erfindung betrifft eine Anordnung aufweisend einen Bildschirm mit einer Bildschirmoberfläche und eine Vorrichtung zur Erzeugung einer haptischen Rückmeldung.

Bei berührungsempfindlichen Bildschirmen ist eine künstlich erzeugte haptische Rückmeldung beim Drücken einer virtuellen Taste erwünscht, um die Bedienbarkeit zu verbessern. Dies ist insbesondere im Automobilbereich von Bedeutung, da dort ein Benutzer nicht permanent auf den Bildschirm blicken kann. Das haptische Feedback kann beispielsweise dazu genutzt werden, um dem Benutzer mitzuteilen, dass von ihm vorgenommene Einstellungen erfolgreich umgesetzt werden.

Bestehende Vorrichtungen zur Erzeugung einer haptischen Rückmeldung sind jedoch zumeist sehr aufwändig und haben eine ineffiziente Übersetzung.

US 6,465,936 B1 zeigt ein Wandlerelement 7, das in einem Gehäuse 8 angeordnet ist (siehe Figur 1), wobei Stirnflächen des Wandlerelements 7 auf einer Innenseite der Seitenfläche 9 des Gehäuses 8 anliegen. In EP 0 902 488 A1 ist ein elektrostriktiver Stellantrieb beschrieben, der ein aus Piezoschichten zusammengesetztes und in Rahmenteile eingefasstes Festkörper-Stellelement aufweist. WO 2014/096565 A1 zeigt, dass Piezoaktuatoren verwendet werden, um eine haptische Rückmeldung bei berührungs-empfindlichen Bildschirmen zu erzeugen. US 2015/309576 A1 zeigt die Verwendung eines piezoelektrischen Sensors bei einer Berührungsfläche zur haptischen Rückmeldung.

US 2011 / 193 824 A1 zeigt eine Vorrichtung mit piezoelektrischen Aktuatoren und einem Bildschirm, wobei die piezoelektrischen Aktuatoren derart mit dem Bildschirm verbunden sind, dass sie diesen in eine Richtung lateral zur Bildschirmoberfläche bewegen können.

Eine zu lösende Aufgabe besteht darin, eine verbesserte Vorrichtung zur Erzeugung einer haptischen Rückmeldung anzugeben, beispielsweise eine Vorrichtung die besonders einfach, platzsparend und/oder kostengünstig ist.

Diese Aufgabe wird durch die Vorrichtung gemäß dem unabhängigen Anspruch gelöst.

Gemäß einem Aspekt wird eine Vorrichtung zur Erzeugung einer haptischen Rückmeldung angegeben. Die Vorrichtung dient als Antrieb für eine haptische Rückmeldung. Die Vorrichtung ist dazu ausgebildet eine haptische Rückmeldung für elektronische Geräte, beispielsweise für berührungsempfindliche Bildschirme, zu erzeugen. Die Vorrichtung ist dazu ausgebildet, einen Versatz des Bildschirms parallel zu einer Bildschirmoberfläche hervorzurufen.

Bildschirm und Vorrichtung (Antrieb) entsprechen in vereinfachter Darstellung einem schwingungsfähigen Masse-Feder-System. Die Resonanzfrequenz f₀ (Frequenz der freien Schwingung ohne Anregung) ergibt sich dabei zu: f₀ = 1/2Π · V(D/m). D ist die Steifigkeit des Antriebs bzw. der Vorrichtung. m ist die Masse des Bildschirms. m liegt in der Regel zwischen 300 g und 400 g.

Die Vorrichtung muss eine bestimmte minimale Steifigkeit D aufweisen, damit der gewünschte Versatz des Bildschirms erreicht werden kann. f₀ muss größer sein als der Kehrwert der Ausschlagdauer T, anderenfalls bewegt sich der Bildschirm nicht oder nur teilweise mit. Ein Versatz soll in der Regel zwischen 7 ms und 10 ms dauern. Damit gilt: D ≥ m (2Π / T)². Bei T = 7 ms und m = 400 g ergibt sich eine minimale Steifigkeit von 0,32 N/µm für die Vorrichtung (Antrieb). Die Steifigkeit wird beispielsweise durch eine Geometrie und/oder ein Material und oder eine Dicke oder vertikale Ausdehnung der Vorrichtung bzw. deren Komponenten beeinflusst.

Die Vorrichtung weist wenigstens einen piezoelektrischen Aktuator auf. Der Aktuator weist eine Vielzahl von piezoelektrischen Schichten auf. Zwischen den piezoelektrischen Schichten sind Innenelektroden abgeordnet. Piezoelektrische Schichten und Innenelektroden sind übereinander zu einem Stapel angeordnet. Vorzugsweise beträgt die Stapelhöhe kleiner oder gleich 3 mm.

Die Vorrichtung weist ferner ein erstes Verstärkungselement auf. Die Vorrichtung weist ein zweites Verstärkungselement auf. Der piezoelektrischen Aktuator ist zwischen den Verstärkungselementen angeordnet. Die Verstärkungselemente dienen zur Vergrößerung der Steifigkeit der Vorrichtung. Die Verstärkungselemente dienen ferner der Hubverstärkung.

Die Verstärkungselemente sind in einer Stapelrichtung der piezoelektrischen Schichten zumindest teilweise auf einer Oberseite und einer Unterseite des Aktuators angeordnet. Die Vorrichtung ist symmetrisch um eine horizontale Achse oder Längsachse der Vorrichtung herum ausgebildet.

Der piezoelektrische Aktuator ist dazu ausgebildet und angeordnet seine Ausdehnung bei Anlegen einer elektrischen Spannung in eine erste Richtung zu verändern. Vorzugsweise erfolgt die Ausdehnung des piezoelektrischen Aktuators bei Anlegen einer elektrischen Spannung quer zur Polarisationsrichtung der piezoelektrischen Schichten und zum elektrischen Feld (d31 Effekt). Vorzugsweise erfolgt die Ausdehnung bei Anlegen einer elektrischen Spannung quer zur Stapelrichtung der piezoelektrischen Schichten.

Das jeweilige Verstärkungselement ist einstückig ausgebildet. Vorzugsweise weist das jeweilige Verstärkungselement einen Teilbereich auf. Die Verstärkungselemente sind dazu ausgebildet und angeordnet, sich in Folge der Änderung der Ausdehnung des piezoelektrischen Aktuators derart zu verformen, dass der Teilbereich des jeweiligen Verstärkungselements relativ zu dem piezoelektrischen Aktuator in eine zweite Richtung bewegt wird. Die zweite Richtung ist senkrecht zur ersten Richtung. Die zweite Richtung verläuft vorzugsweise entlang der Stapelrichtung der piezoelektrischen Schichten.

Wie oben erwähnt, wird durch die Verstärkungselemente der Hub des Aktuators verstärkt. Damit wird ein effektiver Antrieb zur Erzeugung haptischer Rückmeldungen zur Verfügung gestellt. Durch die geringe Stapelhöhe kann als Trennprozess "Cutten" statt "Sägen" verwendet werden. Ferner vereinfacht sich die Kontaktierung des Aktuators. Beides senkt den Herstellungsaufwand und damit die Kosten. Weiterhin ist auf Grund der geringen Höhe nur ein geringer Platzbedarf erforderlich. Insgesamt wird eine Vorrichtung bereitgestellt, die nicht nur die erforderliche Auslenkung zur Erzeugung einer haptischen Rückmeldung bereitstellt, sondern auch einfach, kostengünstig und kompakt ist.

Die Verstärkungselemente weisen jeweils Endbereiche auf. Vorzugsweise weist jedes Verstärkungselement zwei Endbereiche auf. Das jeweilige Verstärkungselement ist vorzugsweise rechteckig bzw. streifenförmig ausgebildet. Das jeweilige Verstärkungselement weist eine Länge und eine Breite auf. Die Länge ist um ein vielfaches größer als die Breite des Verstärkungselements. Beispielweise beträgt die Länge das 5-fache, das 10-fache, das 12-fache oder das 15-fache der Breite. Beispielsweise liegt die Breite des jeweiligen Verstärkungselements zwischen 3 mm und 10 mm.

Beispielsweise liegt die Länge des jeweiligen Verstärkungselements zwischen 50 mm und 100 mm.

Die Endbereiche befinden sind jeweils im Bereich der Stirnflächen des Verstärkungselements. Der jeweilige Endbereich schließt sich unmittelbar an den jeweiligen Teilbereich an. Insbesondere geht der jeweilige Teilbereich zu beiden (Stirn-)Seiten hin in einen Endbereich über. Der Teilbereich stellt folglich einen Mittelbereich des Verstärkungselements dar.

Der Endbereich ist derart ausgebildet und angeordnet, dass bei der Änderung der Ausdehnung des piezoelektrischen Aktuators eine Bewegung des Endbereichs in die zweite Richtung unterbleibt. Folglich tritt eine Relativbewegung zwischen dem jeweiligen Endbereich und dem Teilbereich des Verstärkungselements auf. Die haptische Rückmeldung wird durch die Relativbewegung des jeweiligen Endbereichs zu dem jeweiligen Teilbereich erzeugt. Damit wird eine einfache und effektive Vorrichtung bereitgestellt.

Der Endbereich liegt jeweils unmittelbar an dem piezoelektrischen Aktuator auf. Die Endbereiche des ersten Verstärkungselements liegen auf einer Oberseite, zumindest auf Teilbereichen der Oberseite, des Aktuators auf. Die Endbereiche des zweiten Verstärkungselements liegen auf einer Unterseite, zumindest auf Teilbereichen der Unterseite, des Aktuators auf.

Vorzugsweise sind der jeweilige Endbereich und der piezoelektrischen Aktuator durch eine Klebeverbindung miteinander verbunden. Damit wird eine einfache, kostengünstige und effektive Verbindung zwischen Verstärkungselement und Aktuator erzielt. Die notwendige Steifigkeit der Vorrichtung wird gewährleistet. Auch vereinfacht sich dadurch die Geometrie der Verstärkungselemente. Auf komplizierte Geometrien für die Ausbildung einer Klemmverbindung zwischen Verstärkungselement und Aktuator kann insbesondere verzichtet werden.

Vorzugsweise weist das jeweilige Verstärkungselement einen Metallstreifen auf. Der Metallstreifen ist vorzugsweise gewalzt. Das jeweilige Verstärkungselement kann einen Blechstreifen aufweisen. Das jeweilige Verstärkungselement ist vorzugsweise flach ausgebildet, weist also nur eine geringe maximale Dicke auf. Die maximale Dicke oder vertikale Ausdehnung des Verstärkungselements beträgt vorzugsweise kleiner oder gleich 1,0 mm. Damit wird eine besonders platzsparende Vorrichtung erzielt.

Das jeweilige Verstärkungselement ist gekrümmt bzw. gebogen ausgeführt. Insbesondere weist das Verstärkungselement Bereiche oder Abschnitte auf, die nicht entlang einer Ebene verlaufen, sondern einen Winkel zu einer Längsachse des Verstärkungselements einschließen (schräge Abschnitte). Andere Bereiche oder Abschnitte verlaufen hingegen parallel zur Längsachse. Parallele und schräge Abschnitte gehen direkt bzw. unmittelbar ineinander über. Die spezielle Ausformung der Verstärkungselemente dient dazu die erforderliche Steifigkeit der Vorrichtung zu gewährleisten.

Gemäß einem Ausführungsbeispiel ist der jeweilige Teilbereich von einer Oberfläche des piezoelektrischen Aktuators beabstandet angeordnet. Insbesondere befindet sich ein Freiraum zwischen dem Teilbereich und einer Oberseite bzw. einer Unterseite des Aktuators. Dadurch wird die Bewegung des Teilbereichs in die zweite Richtung ermöglicht. Eine maximale Höhe oder vertikale Ausdehnung des Freiraums beläuft sich beispielsweise auf kleiner oder gleich 2,5 mm, beispielsweise 1,2 mm. Dementsprechend weist die Vorrichtung selbst eine Dicke von kleiner oder gleich 10 mm auf. Dadurch kann eine kompakte und platzsparende Vorrichtung zur Verfügung gestellt werden.

Gemäß der Erfindung weist das jeweilige Verstärkungselement Ausdünnungen, vorzugsweise eine Vielzahl von Ausdünnungen, auf. Durch die Ausdünnung wird die Dicke des Verstärkungselements punktuell verringert. Die Ausdünnung weist eine Tiefe oder vertikale Ausdehnung von kleiner oder gleich 0,8 mm, beispielsweise 0,75 mm, auf. Das jeweilige Verstärkungselement verbiegt sich bei der Bewegung in die zweite Richtung an der Stelle der Ausdünnung. Dadurch wird ein einfaches und stabiles Verstärkungselement erzielt. Die Übersetzung wird durch die Ausdünnung für den Aktuator beweglich und für die Last (Bildschirm) steif. Die Effizienz der Übersetzung wird dadurch gesteigert.

Gemäß einem Ausführungsbeispiel weist die Ausdünnung eine Ausbuchtung in einer Oberfläche des jeweiligen Verstärkungselements auf. Beispielsweise weist die Ausdünnung eine Kerbe auf. Die Ausdünnung kann an einer Oberseite und/oder einer Unterseite des jeweiligen Verstärkungselements ausgebildet sein. Die Ausdünnung kann in eine Oberfläche des Verstärkungselements gestanzt oder gefräst sein. Die Ausdünnung kann ein rundes oder kantiges Profil aufweisen.

Gemäß einem Ausführungsbeispiel ist eine Ausdünnung in einem Übergangsbereich zwischen dem Teilbereich und dem Endbereich des jeweiligen Verstärkungselements ausgebildet. Dadurch kann sich das Verstärkungselement in dem Übergangsbereich verbiegen. Eine Belastung der Verbindung zwischen dem Endbereich des Verstärkungselements und dem Aktuator kann somit verringert werden.

Die Verstärkungselemente weisen einen mittleren Bereich auf.

Die Verstärkungselemente weisen ferner zwei Verbindungsbereiche auf. Die Verbindungsbereiche schließen sich von zwei Seiten her (Stirnseiten) an den mittleren Bereich an. Die Verbindungsbereiche verbinden den mittleren Bereich mit den beiden Endbereichen.

Der mittlere Bereich verläuft parallel zu einer Oberfläche des piezoelektrischen Aktuators. Der Verbindungsbereich verläuft schräg zur Oberfläche des piezoelektrischen Aktuators. In einem Übergangsbereich zwischen dem mittleren Bereich und dem Verbindungsbereich ist eine Ausdünnung ausgebildet. Durch die Ausdünnung kann sich das Verstärkungselement in dem Übergangsbereich verbiegen.

Gemäß einem weiteren Aspekt wird ein elektronisches Gerät angegeben. Das elektronische Gerät weist eine Vorrichtung zur Erzeugung einer haptischen Rückmeldung auf. Die Vorrichtung entspricht insbesondere der oben beschriebenen Vorrichtung. Alle Merkmale, die in Zusammenhang mit der Vorrichtung beschrieben wurden, finden auch im Folgenden für das elektronische Gerät Anwendung.

Die Vorrichtung stellt einen Antrieb für eine haptische Rückmeldung dar. Das elektronische Gerät weist ein erstes mechanisches Element, beispielsweise einen berührungsempfindlichem Bildschirm, auf. Das elektronische Gerät weist ein zweites mechanisches Element, beispielsweise ein Gewicht oder ein Gehäuseelement, auf. Das erste Verstärkungselement ist an dem ersten mechanischen Element befestigt und das zweite Verstärkungselement ist an dem zweiten mechanischen Element befestigt oder umgekehrt. Insbesondere sind die Verstärkungselemente derart an den mechanischen Elementen befestigt, dass bei einer Verformung des piezoelektrischen Aktuators die mechanischen Elemente relativ zueinander bewegt werden. Damit wird ein Versatz des Bildschirms parallel zur Bildschirmoberfläche und folglich eine haptische Rückmeldung für den Benutzer hervorgerufen. Somit wird ein besonders benutzerfreundliches elektrisches Gerät erzielt.

Gemäß einem weiteren Beispiel, das nicht Teil der beanspruchten Erfindung ist, wird die Verwendung einer Vorrichtung beschrieben. Insbesondere wird die Verwendung der oben beschrieben Vorrichtung angegeben. Alle Merkmale, die in Zusammenhang mit der Vorrichtung beschrieben wurden, finden auch für die Verwendung Anwendung. Insbesondere wird die Vorrichtung als Antrieb für eine haptische Rückmeldung bei berührungsempfindlichen Bildschirmen im Automobilbereich verwendet. Durch die Vorrichtung wird ein einfacher, kostengünstiger, platzsparender und effizienter Antrieb zur Verfügung gestellt, mit dem eine haptische Rückmeldung für den Benutzer erzielt werden kann.

Die Erfindung wird im Folgenden anhand von Ausführungsbeispielen und den dazugehörigen Figuren näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.
- Figur 1: zeigt eine Vorrichtung zur Erzeugung einer haptischen Rückmeldung gemäß dem Stand der Technik,
- Figur 2: zeigt eine Schnittansicht einer Vorrichtung zur Erzeugung einer haptischen Rückmeldung,
- Figur 3: zeigt eine perspektivische Ansicht eines Teilbereichs der Vorrichtung gemäß Figur 2,
- Figur 4: zeigt eine perspektivische Ansicht der Vorrichtung gemäß Figur 2,
- Figur 5: zeigt eine perspektivische Ansicht einer Vorrichtung zur Erzeugung einer haptischen Rückmeldung gemäß einem weiteren Ausführungsbeispiel.

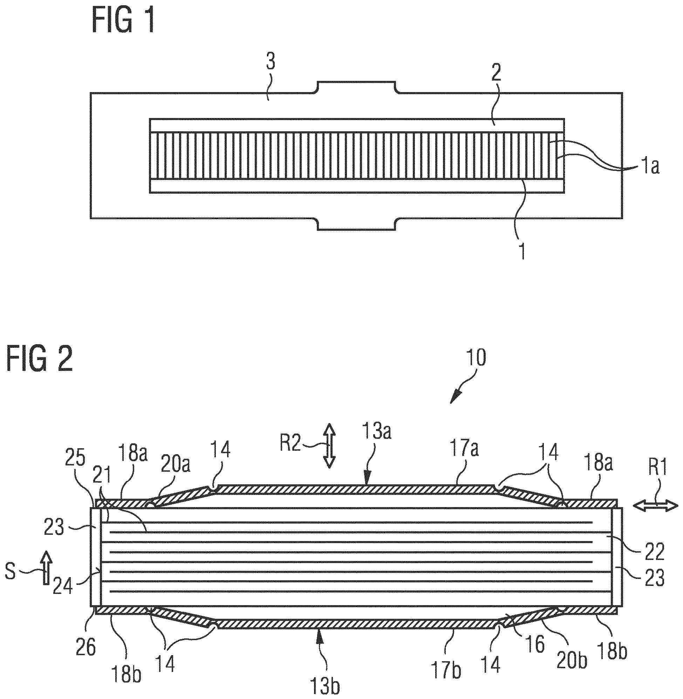

Die Figur 1 zeigt eine Vorrichtung zur Erzeugung einer haptischen Rückmeldung gemäß dem Stand der Technik. Die Vorrichtung weist einen piezoelektrischen Aktuator 1 auf, der eine Vielzahl von piezoelektrischen Schichten 1a und dazwischen angeordneten Innenelektroden aufweist. Die piezoelektrischen Schichten 1a sind in Längsrichtung gestapelt. An gegenüberliegenden Außenflächen des Aktuators 1 ist jeweils eine Metallisierung 2 ausgebildet. Der Aktuator 1 ist beispielsweise in einem Metallgehäuse 3 angeordnet, welches der Hubverstärkung dient.

Die nach dem Stand der Technik bekannte Vorrichtung nutzt den longitudinalen piezoelektrischen Effekt (d33 Effekt) aus. In longitudinalen Aktoren wird das elektrische Feld in der Keramikschicht parallel zur Richtung der Polarisation angelegt. Dadurch wird eine Dehnung oder Auslenkung in Richtung der Polarisation induziert. Einzelne piezoelektrische Schichten 1a liefern dabei relativ geringe Auslenkungen. Um technisch nutzbare Auslenkungswerte zu erreichen, werden daher Stapelaktoren verwendet, in denen eine Vielzahl von piezoelektrischen Schichten 1a mechanisch in Reihe und elektrisch parallel verschaltet sind.

Folglich ist der piezoelektrische Aktuator 1 sehr aufwändig und mit großen Abmessungen gefertigt, wodurch die Vorrichtung voluminös und teuer wird. Ferner haben die piezoelektrischen Schichten 1a des Aktuators 1 eine sehr steife, und ineffiziente Übersetzung.

Im Gegensatz dazu zeigen die Figuren 2 bis 5 eine erfindungsgemäße Vorrichtung 10 zur Erzeugung einer haptischen Rückmeldung, durch welche die oben genannten Nachteile beseitigt werden. Zunächst werden im Folgenden die Figuren 2 bis 4 im Detail betrachtet.

Die Vorrichtung 10 weist einen piezoelektrischen Aktuator 11 auf. Der piezoelektrische Aktuator 11 stellt ein gesintertes Bauelement mit einer Vielzahl von piezoelektrischen Schichten 22 und Innenelektroden 21 dar. Der piezoelektrische Aktuator 11 weist insbesondere eine Vielzahl von piezoelektrischen oder aktiven Schichten 22 auf, die übereinander zu einem Stapel angeordnet sind. Beispielsweise kann der piezoelektrische Aktuator 11 bis zu 100 piezoelektrische Schichten 22, z.B. 70 piezoelektrische Schichten 22, aufweisen. Zwischen den piezoelektrischen Schichten 22 sind die Innenelektroden 21 angeordnet (Figur 2). Dabei sind Innenelektroden 21 unterschiedlicher Polarität alternierend angeordnet.

Bei den piezoelektrischen Schichten 22 kann es sich um Blei-Zirkonat-Titanat-Keramiken (PZT-Keramiken) handeln. Die PZT-Keramik kann ferner zusätzlich Nd und Ni enthalten.

Alternativ kann die PZT-Keramik ferner zusätzlich Nd, K und gegebenenfalls Cu aufweisen. Alternativ können die piezoelektrischen Schichten eine Pb(ZrₓTi₁₋ₓ)O₃ + y Pb(Mn_{1/3}Nb_{2/3})O₃ enthaltenden Zusammensetzung aufweisen.

Die piezoelektrischen Schichten 22 weisen eine Stapelrichtung S auf (Figur 2). Die Stapelrichtung S erstreckt sich entlang von Stirn- bzw. Seitenflächen 24 des Aktuators 11.

Insbesondere sind die piezoelektrischen Schichten 22 entlang einer vertikalen Ausdehnung bzw. Dicke des Aktuators 11 gestapelt.

Der Aktuator 11 weist eine Breite oder erste horizontale Ausdehnung von kleiner oder gleich 10 mm, beispielsweise 5 mm auf. Der Aktuator 11 weist eine Länge oder zweite horizontale Ausdehnung von kleiner oder gleich 100 mm, beispielsweise 60 mm auf. Der Aktuator 11 kann beispielsweise eine Grundfläche von 5 mm x 60 mm (Breite x Länge aufweisen). Der Aktuator 11 weist vorzugsweise eine vertikale Ausdehnung bzw. Dicke auf, die kleiner oder gleich 3 mm beträgt. Beispielsweise weist die jeweilige piezoelektrische Schicht 22 eine Dicke von kleiner oder gleich 40 µm, beispielsweise 39 µm, auf.

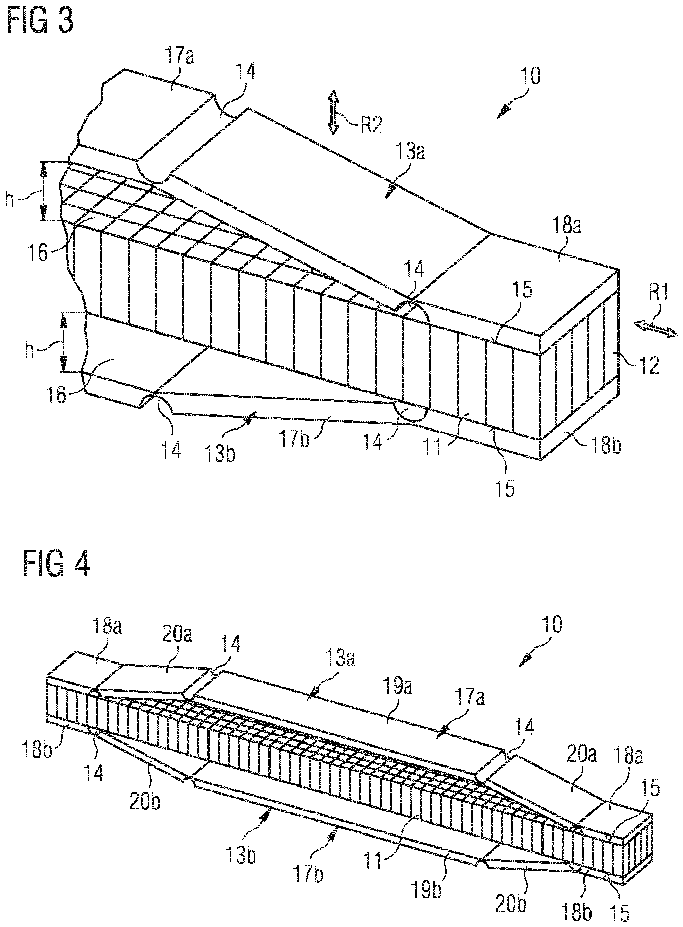

Der Aktuator 11 weist zwei Isolationsbereiche 12 auf (siehe Figur 3). Der jeweilige Isolationsbereich 12 ist in einem Endbereich des Aktuators 11 ausgebildet. Insbesondere ist der jeweilige Isolationsbereich 12 im Bereich einer Stirnfläche 24 des Aktuators 11 ausgebildet. Der jeweilige Isolationsbereich 12 weist eine Länge von kleiner oder gleich 2 mm auf.

Im Isolationsbereich 12 reichen nur Innenelektroden 21 einer Polarität bis an die Stirnfläche 24 des Aktuators 11. Der Isolationsbereich 12 kann zur Kontaktierung des Aktuators 11 verwendet werden. Beispielsweise kann der jeweilige Isolationsbereich 12 mit Außenelektroden 23 zur elektrischen Kontaktierung versehen werden (Figur 2).

Der Aktuator 11 ist so ausgestaltet, dass bei Anlegen einer elektrischen Spannung eine Verformung des Aktuators 1 stattfindet (Ausdehnung in Richtung R1, siehe Figuren 2 und 3). Insbesondere sind die piezoelektrischen Schichten 22 derart polarisiert, dass das Anlegen einer elektrischen Spannung zwischen den Innenelektroden 21 zu einer Querkontraktion des Aktuators 11 führt, bei der sich die Länge des Aktuators 11 senkrecht zur Stapelrichtung S verändert. Folglich erfolgt eine Ausdehnung des Aktuators 1 quer zur Polarisationsrichtung und zum elektrischen Feld (d31 Effekt).

Um den Effekt der Längenänderung in Stapelrichtung S weiter zu verstärken weist die Vorrichtung zwei Verstärkungselemente 13a, 13b auf. Wird an den Aktuator 11 Spannung angelegt, so verformen sich die Verstärkungselemente 13a, 13b zumindest teilweise in Folge der Änderung der Ausdehnung des Aktuators 11, wie später im Detail beschrieben wird.

Der Aktuator 11 ist zwischen den Verstärkungselementen 13a, 13b angeordnet. Die Verstärkungselemente 13a, 13b liegen zumindest teilweise auf einer Oberseite 25 bzw. einer Unterseite 26 des Aktuators 11 auf. Das jeweilige Verstärkungselement 13a, 13b weist vorzugsweise eine Breite auf, welche der Breite des Aktuators 11 entspricht. Gleiches gilt vorzugsweise für die Länge der Verstärkungselemente 13a, 13b. Vorzugsweise weist das jeweilige Verstärkungselement 13a, 13b eine Grundfläche von 5 mm x 60 mm (Breite x Länge) auf.

Das jeweilige Verstärkungselement 13a, 13b ist einstückig ausgebildet. Das jeweilige Verstärkungselement 13a, 13b weist eine rechteckige Form auf. Das jeweilige Verstärkungselement 13a, 13b ist streifenförmig ausgebildet. Das jeweilige Verstärkungselement 13a, 13b ist gekrümmt bzw. verbogen ausgebildet. Beispielsweise weist das jeweilige Verstärkungselement einen Blechstreifen auf. Der Blechstreifen ist gebogen, wie im Folgenden im Detail erläutert wird.

Jedes der einstückigen Verstärkungselemente 13a, 13b ist in mehrere Bereiche oder Abschnitte untergliedert. So weist das jeweilige Verstärkungselement 13a, 13b einen Teilbereich oder ersten Bereich 17a, 17b auf. Der Teilbereich 17a, 17b weist jeweils einen ersten Abschnitt oder mittleren Bereich 19a, 19b auf (Figur 4). Der mittlere Bereich 19a, 19b weist eine Länge von kleiner oder gleich 4 mm, vorzugsweise 3 mm, auf.

Der Teilbereich 17a, 17b weist ferner jeweils zwei zweite Abschnitte oder Verbindungsbereiche 20a, 20b auf (Figuren 2 und 4). Die beiden Verbindungsbereiche 20a, 20b des jeweiligen Verstärkungselements 13a, 13b schließen sich unmittelbar an den mittleren Bereich 19a, 19b des jeweiligen Verstärkungselements 13a, 13b an. Der mittlere Bereich 19a, 19b des jeweiligen Verstärkungselements 13a, 13b ist mit anderen Worten von den beiden Verbindungsbereichen 20a, 20b zu beiden Seiten hin umgeben.

Das jeweilige Verstärkungselement 13a, 13b weist ferner zwei Endbereiche 18a, 18b auf. Der jeweilige Endbereich 18a, 18b weist vorzugsweise eine Länge von kleiner oder gleich 5 mm, beispielsweise 4,5 mm, auf. Die Endbereiche 18a, 18b schließen sich unmittelbar an die Verbindungsbereiche 20a, 20b des jeweiligen Verstärkungselements 13a, 13b an. Mit andere Worten verbindet jeweils ein Verbindungsbereich 20a, 20b einen Endbereich 18a, 18b mit dem mittleren Bereich 19a, 19b eines Verstärkungselements 13a, 13b.

Die beiden Endbereiche 18a, 18b des jeweiligen Verstärkungselements liegen unmittelbar auf einer Oberfläche des Aktuators 11 auf. So liegen der erste und der zweite Endbereich 18a des ersten Verstärkungselements 13a auf einem Teilbereich der Oberseite 25 des Aktuators 11 auf. Weiterhin liegen der erste und der zweite Endbereich 18b des zweiten Verstärkungselements 13b auf einem Teilbereich der Unterseite 26 des Aktuators 11 auf.

Die Endbereiche 18a, 18b sind vorzugsweise unlösbar mit der Oberfläche des Aktuators 11 verbunden. Insbesondere sind die Endbereiche 18a, 18b mit der Oberfläche des Aktuators 11 durch eine Klebeverbindung verbunden. Eine Unterseite des jeweiligen Endbereichs 18a, 18b bildet zusammen mit einem Teilbereich der Oberseite 25 bzw. Unterseite 26 des Aktuators 11 eine Klebefläche 15 (Figuren 3 und 4). Auf die Klebefläche 15 wird Klebematerial aufgebracht und die Verstärkungselemente 13a, 13b auf diese Weise mit dem Aktuator 11 verbunden. Durch den Einsatz einer Klebeverbindung an Stelle von beispielsweise einer Klemmverbindung kann die Geometrie der Verstärkungselemente 13a, 13b sehr einfach gehalten werden.

Der jeweilige Teilbereich 17a, 17b ist von der Oberfläche des Aktuators 11 beabstandet. Insbesondere befindet sich zwischen dem jeweiligen Teilbereich 17a, 17b und der Unterseite 26 bzw. der Oberseite 25 des Aktuators 11 ein Freibereich 16 (Figuren 2 und 3). Der Freibereich 16 weist eine Höhe h auf (Figur 3). Die maximale Höhe h und damit der maximale Abstand zwischen dem Aktuator 11 und dem Teilbereich 17a, 17b beträgt vorzugsweise kleiner oder gleich 3 mm, bevorzugt 2,5 mm. Damit ergibt sich eine maximale Gesamtdicke der Vorrichtung 10 von vorzugsweise 10 mm.

Die Höhe h des Freibereichs 16 variiert entlang des jeweiligen Teilbereichs 17a, 17b. So ist der mittlere Bereich 19a, 19b des jeweiligen Teilbereichs 17a, 17b so ausgebildet, dass er parallel zu der Oberfläche des Aktuators 11 verläuft. Damit ist die Höhe h des Freibereichs 16 im Bereich des mittleren Bereichs 19a, 19b maximal. Der jeweilige Verbindungsbereich 20a, 20b verläuft hingegen schräg zur Oberfläche des Aktuators 11. Mit anderen Worten der jeweilige Verbindungsbereich 20a, 20b schließt einen Winkel mit der Oberseite 25 bzw. der Unterseite 26 des Aktuators 11 ein. Der Winkel ist vorzugsweise kleiner oder gleich 45°. Damit verkleinert sich die Höhe h des Freibereichs 16 in Richtung von mittleren Bereich 19a, 19b hin zum Endbereich 18a, 18b des jeweiligen Verstärkungselements 13a, 13b. Folglich weist das jeweilige Verstärkungselement 13a, 13b eine gebogene Form auf.

Das jeweilige Verstärkungselement 13a, 13b weist ferner wenigstes eine Ausdünnung 14, vorzugsweise mehrere Ausdünnungen 14, auf. In den Figuren 2 bis 5 weist das jeweilige Verstärkungselement 13a, 13b vier Ausdünnungen 14 auf. Die Ausdünnungen 14 können dabei als ein Bereich angesehen werden, in dem das jeweilige Verstärkungselement 13a 13b dünner ist, also eine geringere vertikale Ausdehnung oder Dicke hat, als im übrigen Bereich. Eine Ausdünnung 14 weist vorzugsweise eine Tiefe oder vertikale Ausdehnung von kleiner oder gleich 0,8 mm, vorzugsweise 0,75 mm, auf. Die maximale Dicke des jeweiligen Verstärkungselements 13, 13b beträgt vorzugsweise 1 mm. An der Stelle einer Ausdünnungen 14 weist das jeweilige Verstärkungselement 13a, 13b damit eine Restdicke von 0,25 mm auf.

Die Ausdünnungen 14 weisen beispielsweise Kerben auf. Die Ausdünnung 14 kann eine halbrunde Form aufweisen. Jedoch ist die Form der jeweiligen Ausdünnung 14 für deren Funktion unerheblich. Die Ausdünnungen 14 sind an einer Oberseite und/oder Unterseite des jeweiligen Verstärkungselements 13a, 13b ausgebildet. Beispielsweise sind die Ausdünnungen 14 in der Oberseite und/oder die Unterseite gestanzt oder gefräst.

Die Ausdünnungen 14 können nach außen hin geöffnet sein. Für das jeweilige Verstärkungselement 13a, 13b bedeutet dies, die Ausdünnung 14 kann an einer Außenseite des Verstärkungselements 13a, 13b angeordnet sein, die von der Oberseite 25 bzw. Unterseite 26 des Aktuators 11 abgewandt ist. Die Ausdünnungen 14 können auch nach innen hin geöffnet sein. Für das jeweilige Verstärkungselement 13a, 13b bedeutet dies, die Ausdünnung 14 kann an einer Außenseite des Verstärkungselements 13a, 13b angeordnet sein, die zu der Oberseite 25 bzw. Unterseite 26 des Aktuators 11 hingewandt ist. Das jeweilige Verstärkungselement 13a, 13b kann sowohl nach innen als auch nach außen hin geöffnete Ausdünnungen 14 aufweisen. Das jeweilige Verstärkungselement 13a, 13b kann auch nur einseitige Ausdünnungen 14 aufweisen, also Ausdünnungen 14, die entweder nach außen oder nach innen hin geöffnet sind.

Die Ausdünnungen 14 sind dazu vorgesehen, dass sich das Verstärkungselement 13a, 13b an der Stelle der Ausdünnung 14 bei Auslenkung des Aktuators 11 verbiegen kann.

Bevorzugt sind die Ausdünnungen 14 in Übergangsbereichen des jeweiligen Verstärkungselements 13a, 13b ausgebildet. Eine Ausdünnung 14 ist dabei jeweils im Übergangsbereich zwischen Verbindungsbereich 20a, 20b und Endbereich 18a, 18b ausgebildet. Diese Ausdünnungen 14 sind in dem Ausführungsbeispiel nach Figuren 2bis 4 nach innen hin geöffnet. Ferner findet sich jeweils eine Ausdünnung 14 im Übergangsbereich zwischen mittlerem Bereich 19a, 19b und Verbindungsbereich 20a, 20b. Diese Ausdünnungen 14 sind in dem Ausführungsbeispiel nach Figuren 2 bis 4 nach außen hin geöffnet.

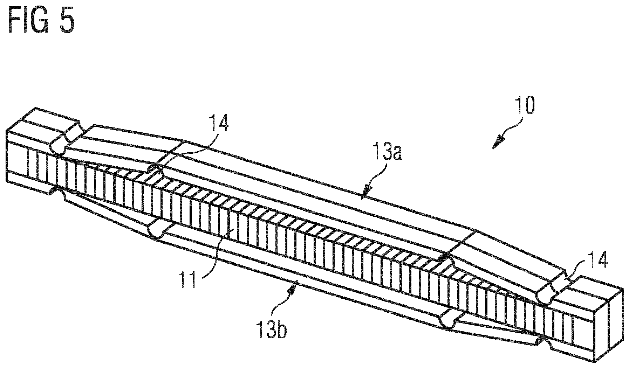

Gemäß einem weiteren Ausführungsbeispiel (Figur 5) können die Ausdünnungen 14 aber auch "umgedreht" werden, um die Gesamthöhe der Vorrichtung 10 zu reduzieren. So sind in Figur 5 die Ausdünnungen 14 im Übergangsbereich zwischen Verbindungsbereich 20a, 20b und Endbereich 18a, 18b nach außen hin geöffnet. Die Ausdünnungen 14 im Übergangsbereich zwischen mittlerem Bereich 19a, 19b und Verbindungsbereich 20a, 20b sind nach innen hin geöffnet. Wird die maximale Höhe 6 des Freibereichs 16 auf lediglich 1,16 mm gesetzt, so beträgt die Gesamthöhe der Vorrichtung 10 aus Figur 5 lediglich kleiner oder gleich 7,5 mm, bevorzugt 7,36 mm.

In den Übergangsbereichen muss sich das Verstärkungselement 13a, 13b verbiegen, wenn sich der Aktuator 11 verformt. Die Ausdünnungen 14 stellen die nötige Flexibilität des Verstärkungselements 13a, 13b sicher. Die Übersetzung wird dadurch für den Aktuator 11 beweglich und für die Last, beispielsweise einen berührungsempfindlichem Bildschirm, steif. Dadurch wird die Effizienz der Übersetzung gesteigert.

Wird nun an den Aktuator 11 Spannung angelegt, so bewegen sich die Teilbereiche 17a, 17b des jeweiligen Verstärkungselements 13a, 13b relativ zum Aktuator 11 in eine zweite Richtung R2 (Figuren 2 und 3). Die zweite Richtung R2 ist senkrecht zur ersten Richtung R1. Die zweite Richtung R2 verläuft entlang der Stapelrichtung S.

Insbesondere bewegen sich die mittleren Bereiche 19a, 19b in Richtung R2. Dabei biegt sich das jeweilige Verstärkungselement 13a, 13b an Stelle der Ausdünnungen 14 zwischen mittlerem Bereich 19a, 19b Verbindungsbereichen 20a, 20b sowie zwischen Verbindungsbereichen 20a, 20b und Endbereichen 18a, 18b.

Hingegen wird eine Bewegung der Endbereiche 18a, 18b in die zweite Richtung R2 durch die Klebeverbindung mit dem Aktuator 11 verhindert. Vielmehr bewegen sich die Endbereiche 18a, 18b mit dem Aktuator 11 in die erste Richtung R1. Durch die Flexibilität der Verstärkungselement 13a, 13b beschränkt sich die Belastung der Klebungen dabei auf kleiner oder gleich 50 MPa. Es findet damit eine Relativbewegung zwischen den Endbereichen 18a, 18b und den Teilbereichen 17a, 17b statt. Die haptische Rückmeldung der Vorrichtung 10 wird durch die Relativbewegung des jeweiligen Endbereichs 18a, 18b zu dem jeweiligen Teilbereich 17a, 17b hervorgerufen.

Wird die Vorrichtung 10 als Antrieb für eine haptische Rückmeldung in ein elektronisches Gerät integriert, so werden die Verstärkungselemente 13, 13b vorzugsweise an mechanischen Elementen (beispielsweise einen Bildschirm und einem Gewicht) befestigt. Damit werden die mechanischen Elemente bei einer Verformung des piezoelektrischen Aktuators 11 relativ zueinander bewegt. Mit anderen Worten, der Bildschirm wird seitlich (parallel zur Bildschirmoberfläche) versetzt und dadurch wird eine haptische Rückmeldung erzeugt.

Es sind Verschiebungen im Bereich von 100 µm bis 150 µm vorstellbar. Auch einzelne Ausschläge (Versatz und Rückversatz) sind möglich. Ein Versatz soll in der Regel zwischen 7 ms und 10 ms dauern. Der seitliche Versatz wird angewendet, da bei einem vertikalen Versatz (senkrecht zur Oberfläche) wegen der geringen Biegefestigkeit des Bildschirms der Bildschirm an mehreren Stellen angetrieben werden müsste. Bei seitlichem Versatz ist der Einsatz einer wie oben beschriebenen Vorrichtung 10 ausreichend.

Die Bildschirme haben in der Regel eine Masse zwischen 300 g und 400 g. Bildschirm und Vorrichtung 10 (Antrieb) sind in vereinfachter Darstellung ein schwingungsfähiges Masse-FederSystem. Die Resonanzfrequenz f₀ (Frequenz der freien Schwingung ohne Anregung) ergibt sich zu: f₀ = 1/2Π · √(D/m). Dabei ist D die Steifigkeit des Antriebs und m die Masse des Bildschirms. f₀ muss größer sein als der Kehrwert der Ausschlagsdauer T, ansonsten bewegt sich der Bildschirm nicht oder nur teilweise mit. Damit gilt: D ≥ m (2Π / T)². Bei T = 7 ms und m = 400 g ergibt sich damit eine minimale Steifigkeit von 0,32 N/µm für die Vorrichtung 10 (Antrieb).

Für die oben beschriebene Vorrichtung 10 gemäß der Figuren 2 bis 5 ergibt sich bei einer Spannung von 100 V ein Hub von 117 µm, eine Blockierkraft von 46 N und damit eine Steifigkeit von 0,4 N/µm.

Zum Vergleich des Leistungsvermögens einer Übersetzung kann die maximal übertragbare Energie Eₘₐₓ herangezogen werden, bei gegebenem Aktuator 11 mit Ansteuerung. Eₘₐₓ = (freier Weg · Blockierkraft) / 2. Dieser Wert beträgt bei der oben beschriebenen Vorrichtung 2,7 mJ.

Im Falle des Fehlens der erfindungsgemäßen Ausdünnungen 14 und einer angenommenen Dicke des jeweiligen Verstärkungselements 13a, 13b von 0,5 mm und Höhe h von 1,75 mm würde eine Auslenkung von nur 102 µm erreicht werden und eine Blockierkraft von 40 N. Dies würde eine Steifigkeit von 0,38 N/µM und Emax 2,0 mJ ergeben.

Die Erfindung ist nicht durch die Beschreibung anhand der Ausführungsbeispiele beschränkt.

### Bezugszeichenliste

- 1: Piezoelektrischer Aktuator
- 1a: Piezoelektrische Schicht
- 2: Außenelektrode
- 3: Metallgehäuse

- 10: Vorrichtung
- 11: Piezoelektrischen Aktuator
- 12: Isolationsbereich
- 13a: Erstes Verstärkungselement
- 13b: Zweites Verstärkungselement
- 14: Ausdünnung
- 15: Klebefläche
- 16: Freibereich
- 17a, 17b: Teilbereich / Erster Bereich
- 18a, 18b: Endbereich / Zweiter Bereich
- 19a, 19b: Erster Abschnitt des Teilbereichs / mittlerer Bereich
- 20a, 20b: Zweiter Abschnitt des Teilbereichs / Verbindungsbereich
- 21: Innenelektrode
- 22: Piezoelektrische Schicht
- 23: Außenelektrode
- 24: Stirnfläche
- 25: Oberseite
- 26: Unterseite

- h: Höhe
- R1: Erste Richtung
- R2: Zweite Richtung
- S: Stapelrichtung

## Patentansprüche

1. Anordnung aufweisend einen Bildschirm mit einer Bildschirmoberfläche und eine Vorrichtung (10) zur Erzeugung einer haptischen Rückmeldung, aufweisend
- wenigstens einen piezoelektrischen Aktuator (11) aufweisend eine Vielzahl von piezoelektrischen Schichten (22),
- ein erstes Verstärkungselement (13a) und ein zweites Verstärkungselement (13b), wobei der piezoelektrische Aktuator (11) zwischen den Verstärkungselementen (13a, 13b) angeordnet ist, wobei das erste Verstärkungselement (13a) an einem ersten mechanischen Element befestigt ist, wobei es sich bei dem ersten mechanischen Elemente um den Bildschirm handelt, wobei das zweite Verstärkungselement (13b) an einem zweiten mechanischen Element befestigt ist,
wobei das erste mechanisches Element und das zweite mechanisches Element derart an dem jeweiligen Verstärkungselement (13a, 13b) befestigt sind, dass bei einer Verformung des piezoelektrischen Aktuators (11) die mechanischen Elemente relativ zueinander bewegt werden,
wobei der piezoelektrische Aktuator (11) dazu ausgebildet und angeordnet ist, seine Ausdehnung bei Anlegen einer elektrischen Spannung in eine erste Richtung (R1) zu verändern und wobei die Verstärkungselemente (13a, 13b) dazu ausgebildet und angeordnet sind, sich in Folge der Änderung der Ausdehnung des piezoelektrischen Aktuators (11) derart zu verformen, dass ein mittlerer Bereich (19a) des ersten Verstärkungselements (13a) relativ zu dem piezoelektrischen Aktuator (11) in eine zweite Richtung (R2), die senkrecht zur ersten Richtung (R1) sowie senkrecht zu einer Oberseite (25) und einer Unterseite (26) des piezoelektrischen Aktuators (11) ist, bewegt wird, und dass ein mittlerer Bereich (19b) des zweiten Verstärkungselements (13b) in eine zur zweiten Richtung (R2) entgegengesetzte Richtung bewegt wird,
wobei die Vorrichtung (10) dazu ausgebildet und angeordnet ist, einen Versatz des Bildschirms parallel zu der Bildschirmoberfläche hervorzurufen,
**gekennzeichnet dadurch, dass** die Verstärkungselemente (13a, 13b) je zwei Verbindungsbereiche (20a, 20b) aufweisen, die sich von zwei Seiten her an den mittleren Bereich (19a, 19b) anschließen,
wobei der jeweilige mittlere Bereich (19a, 19b) parallel zu der Oberseite (25) und der Unterseite (26) des piezoelektrischen Aktuators (11) verläuft, wobei in einem Übergangsbereich zwischen dem mittleren Bereich (19a, 19b) und dem Verbindungsbereich (20a, 20b) je eine Ausdünnung (14) ausgebildet ist, wobei sich das jeweilige Verstärkungselement (13a, 13b) bei der Bewegung in die zweite Richtung (R2) an der Stelle der Ausdünnung (14) verbiegt, und
wobei das erste Verstärkungselement (13a) Endbereiche (18a) aufweist, die auf der Oberseite (25) des Aktuators (11) aufliegen und wobei das zweite Verstärkungselement (13b) Endbereiche (18b) aufweist, die auf der Unterseite (26) des Aktuators (11) aufliegen.

2. Anordnung gemäß Anspruch 1,
wobei durch den Versatz des Bildschirms parallel zur Bildschirmoberfläche die haptische Rückmeldung erzeugt wird.

3. Anordnung nach Anspruch 1 oder Anspruch 2,
wobei die Ausdehnung des piezoelektrischen Aktuators (11) bei Anlegen einer elektrischen Spannung quer zur Polarisationsrichtung der piezoelektrischen Schichten (22) und zum elektrischen Feld erfolgt.

4. Anordnung nach einem der Ansprüche 1 bis 3,
wobei die Endbereiche (18a, 18b) derart ausgebildet und angeordnet sind, dass bei der Änderung der Ausdehnung des piezoelektrischen Aktuators (11) eine Bewegung der Endbereiche (18a, 18b) in die zweite Richtung (R2) unterbleibt, und wobei die haptische Rückmeldung durch eine Relativbewegung des jeweiligen Endbereichs (18a, 18b) zu dem jeweiligen mittleren Bereich (19a, 19b) erzeugt wird.

5. Anordnung nach einem der Ansprüche 1 bis 4,
wobei die Endbereiche (18a, 18b) unlösbar mit der Oberfläche des Aktuators (11) verbunden sind.

6. Anordnung nach einem der Ansprüche 1 bis 5,
wobei der jeweilige Endbereich (18a, 18b) und der piezoelektrische Aktuator (11) durch eine Klebeverbindung miteinander verbunden sind.

7. Anordnung nach einem der Ansprüche 1 bis 6,
wobei der jeweilige mittlere Bereich (19a, 19b) von einer Oberfläche des piezoelektrischen Aktuators (11) beabstandet angeordnet ist.

8. Anordnung nach einem der Ansprüche 1 bis 7,
wobei die Verstärkungselemente (13a, 13b) jeweils einen Teilbereich (17a, 17b) aufweisen, der den mittleren Bereich (19a, 19b) und die Verbindungsbereiche (20a, 20b) enthält, und sich die Endbereiche (18a, 18b) des jeweiligen Verstärkungselements (13, 13b) unmittelbar an den Teilbereich (17a, 17b) anschließen.

9. Anordnung nach Anspruch 8,
wobei es sich bei den Endbereichen (18a, 18b) der Verstärkungselemente (13a, 13b) um jeweils zwei Endbereiche (18a, 18b) für das jeweilige Verstärkungselement (13a, 13b) handelt, die an gegenüberliegenden Seiten des Teilbereichs (17a, 17b) des jeweiligen Verstärkungselements (13, 13b) angeordnet sind und unmittelbar an den Teilbereich (17a, 17b) anschließen.

10. Anordnung nach einem der Ansprüche 1 bis 9,
wobei die Ausdünnung (14) eine Ausbuchtung in einer Oberfläche des jeweiligen Verstärkungselements (13a, 13b) aufweist.

11. Anordnung nach einem der Ansprüche 1 bis 10,
wobei das jeweilige Verstärkungselement (13a, 13b) eine Vielzahl von Ausdünnungen (14) aufweist.

12. Anordnung nach einem der vorangehenden Ansprüche,
wobei das jeweilige Verstärkungselement (13a, 13b) einen Metallstreifen oder Blechstreifen aufweist.

13. Anordnung nach einem der vorangehenden Ansprüche,
wobei das jeweilige Verstärkungselement (13a, 13b) einstückig ausgebildet ist.

## Claims

1. Assembly having a screen having a screen surface and a device (10) for generating haptic feedback, having
- at least one piezoelectric actuator (11) having a multiplicity of piezoelectric layers (22),
- a first reinforcement element (13a) and a second reinforcement element (13b), wherein the piezoelectric actuator (11) is disposed between the reinforcement elements (13a, 13b), wherein the first reinforcement element (13a) is fastened to a first mechanical element, wherein the first mechanical element is the screen, wherein the second reinforcement element (13b) is fastened to a second mechanical element,
wherein the first mechanical element and the second mechanical element are fastened to the respective reinforcement element (13a, 13b) in such a manner that the mechanical elements are converged when the piezoelectric actuator (11) is deformed, wherein the piezoelectric actuator (11) is configured and disposed so as to change its extent in a first direction (R1) when an electric voltage is applied and wherein the reinforcement elements (13a, 13b) are configured and disposed so as to deform, as a consequence of the change in the extent of the piezoelectric actuator (11), in such a manner that a central region (19a) of the first reinforcement element (13a) is moved relative to the piezoelectric actuator (11) in a second direction (R2), which is perpendicular to the first direction (R1) as well as perpendicular to an upper side (25) and a lower side (26) of the piezoelectric actuator (11), and that a central region (19b) of the second reinforcement element (13b) is moved in a direction counter to the second direction (R2),
wherein the device (10) is configured and disposed so as to cause an offset of the screen parallel to the screen surface,
**characterized in that** the reinforcement elements (13a, 13b) have in each case two connecting regions (20a, 20b) which adjoin the central region (19a, 19b) from two sides,
wherein the respective central region (19a, 19b) runs parallel to the upper side (25) and the lower side (26) of the piezoelectric actuator (11), wherein a thin place (14) is in each case configured in a transition region between the central region (19a, 19b) and the connecting region (20a, 20b),
wherein the respective reinforcement element (13a, 13b) when moving in the second direction (R2) bends at the location of the thin place (14), and
wherein the first reinforcement element (13a) has end regions (18a) which bear on the upper side (25) of the actuator (11) and wherein the second reinforcement element (13b) has end regions (18b) which bear on the lower side (36) of the actuator (11) .

2. Assembly according to Claim 1,
wherein the haptic feedback is generated by the offset of the screen parallel to the screen surface.

3. Assembly according to Claim 1 or Claim 2,
wherein the extension of the piezoelectric actuator (11) takes place when an electric voltage is applied transversely to the direction of polarization of the piezoelectric layers (22) and to the electric field.

4. Assembly according to one of Claims 1 to 3,
wherein the end regions (18a, 18b) are configured and disposed in such a manner that a movement of the end regions (18a, 18b) in the second direction (R2) does not take place when the extent of the piezoelectric actuator (11) changes, and wherein the haptic feedback is generated by a relative movement of the respective end region (18a, 18b) in relation to the respective central region (19a, 19b).

5. Assembly according to one of Claims 1 to 4,
wherein the end regions (18a, 18a) are non-releasably connected to the surface of the actuator (11) .

6. Assembly according to one of Claims 1 to 5,
wherein the respective end region (18a, 18b) and the piezoelectric actuator (11) are connected to one another by an adhesive bond.

7. Assembly according to one of Claims 1 to 6,
wherein the respective central region (19a, 19b) is disposed so as to be spaced apart from a surface of the piezoelectric actuator (11).

8. Assembly according to one of Claims 1 to 7,
wherein the reinforcement elements (13a, 13b) have in each case one sub-region (17a, 17b) which contains the central region (19a, 19b) and the connecting regions (20a, 20b), and the end regions (18a, 18b) of the respective reinforcement element (13, 13b) directly adjoin the sub-region (17a, 17b).

9. Assembly according to Claim 8,
wherein the end regions (18a, 18b) of the reinforcement elements (13a, 13b) are in each case two end regions (18a, 18b) for the respective reinforcement element (13a, 13b), which are disposed on opposite sides of the sub-region (17a, 17b) of the respective reinforcement element (13, 13b) and directly adjoin the sub-region (17a, 17b).

10. Assembly according to one of Claims 1 to 9,
wherein the thin place (14) has a convexity in a surface of the respective reinforcement element (13a, 13b).

11. Assembly according to one of Claims 1 to 10,
wherein the respective reinforcement element (13a, 13b) has a multiplicity of thin places (14).

12. Assembly according to one of the preceding claims, wherein the respective reinforcement element (13a, 13b) has a metal strip or sheet-metal strip.

13. Assembly according to one of the preceding claims, wherein the respective reinforcement element (13a, 13b) is integrally configured.

## Revendications

1. Ensemble comprenant un écran avec une surface d'écran et un dispositif (10) pour générer un retour haptique, comprenant
- au moins un actionneur piézoélectrique (11) comprenant une pluralité de couches piézoélectriques (22),
- un premier élément de renforcement (13a) et un deuxième élément de renforcement (13b), l'actionneur piézoélectrique (11) étant disposé entre les éléments de renforcement (13a, 13b), le premier élément de renforcement (13a) étant fixé à un premier élément mécanique, le premier élément mécanique étant l'écran, le deuxième élément de renforcement (13b) étant fixé à un deuxième élément mécanique,
le premier élément mécanique et le deuxième élément mécanique étant fixés à l'élément de renforcement respectif (13a, 13b) de telle sorte que, lors d'une déformation de l'actionneur piézoélectrique (11), les éléments mécaniques sont déplacés l'un par rapport à l'autre,
l'actionneur piézoélectrique (11) étant conçu et agencé de façon à modifier son extension dans une première direction (R1) lors de l'application d'une tension électrique, et dans lequel les éléments de renforcement (13a, 13b) sont conçus et agencés de façon à se déformer, suite à la modification de l'extension de l'actionneur piézoélectrique (11), de telle sorte qu'une zone médiane (19a) du premier élément de renforcement (13a) soit orientée dans une deuxième direction (R2) par rapport à l'actionneur piézoélectrique (11), qui est perpendiculaire à la première direction (R1) ainsi que perpendiculaire à une face supérieure (25) et à une face inférieure (26) de l'actionneur piézoélectrique (11), et en ce qu'une zone médiane (19b) du deuxième élément de renforcement (13b) est déplacée dans une direction opposée à la deuxième direction (R2),
le dispositif (10) étant conçu et agencé de façon à provoquer un décalage de l'écran parallèlement à la surface de l'écran,
**caractérisé en ce que** les éléments de renforcement (13a, 13b) présentent chacun deux zones de liaison (20a, 20b) qui se raccordent à la zone médiane (19a, 19b) à partir de deux côtés, la zone médiane respective (19a, 19b) s'étend parallèlement à la face supérieure (25) et à la face inférieure (26) de l'actionneur piézoélectrique (11), un amincissement (14) étant formé dans une zone de transition entre la zone médiane (19a, 19b) et la zone de liaison (20a, 20b), l'élément de renforcement respectif (13a, 13b) fléchit lors du déplacement dans la deuxième direction (R2) à l'endroit de l'amincissement (14), et
le premier élément de renforcement (13a) présente des zones d'extrémité (18a) qui reposent sur la face supérieure (25) de l'actionneur (11) et le deuxième élément de renforcement (13b) présente des zones d'extrémité (18b) qui reposent sur la face inférieure (26) de l'actionneur (11).

2. Ensemble selon la revendication 1,
dans lequel le décalage de l'écran parallèlement à la surface de l'écran permet de générer le retour haptique.

3. Ensemble selon la revendication 1 ou la revendication 2,
dans lequel l'extension de l'actionneur piézoélectrique (11) se fait lors de l'application d'une tension électrique, transversalement au sens de polarisation des couches piézoélectriques (22) et au champ électrique.

4. Ensemble selon l'une des revendications 1 à 3,
dans lequel les zones d'extrémité (18a, 18b) sont réalisées et disposées de telle sorte que, lors de la modification de l'extension de l'actionneur piézoélectrique (11), il n'y a pas de mouvement des zones d'extrémité (18a, 18b) dans la deuxième direction (R2), et dans lequel le retour haptique est généré par un mouvement relatif de la zone d'extrémité respective (18a, 18b) par rapport à la zone médiane respective (19a, 19b).

5. Ensemble selon l'une des revendications 1 à 4,
dans lequel les zones d'extrémité (18a, 18b) sont reliées de manière indissociable à la surface de l'actionneur (11) .

6. Ensemble selon l'une des revendications 1 à 5,
dans lequel chaque zone d'extrémité (18a, 18b) et l'actionneur piézoélectrique (11) sont reliés entre eux par une liaison adhésive.

7. Ensemble selon l'une des revendications 1 à 6,
dans lequel la zone médiane respective (19a, 19b) est disposée à distance d'une surface de l'actionneur piézoélectrique (11).

8. Ensemble selon l'une des revendications 1 à 7,
dans lequel les éléments de renforcement (13a, 13b) présentent chacun une zone partielle (17a, 17b) comprenant la zone médiane (19a, 19b) et les zones de liaison (20a, 20b), et les zones d'extrémité (18a, 18b) de l'élément de renforcement respectif (13, 13b) se raccordent directement à la zone partielle (17a, 17b).

9. Ensemble selon la revendication 8,
dans lequel les zones d'extrémité (18a, 18b) des éléments de renforcement (13a, 13b) sont respectivement deux zones d'extrémité (18a, 18b) pour l'élément de renforcement respectif (13a, 13b), qui sont disposées sur des côtés opposés de la zone partielle (17a, 17b) de l'élément de renforcement respectif (13a, 13b) et qui se raccordent directement à la zone partielle (17a, 17b).

10. Ensemble selon l'une quelconque des revendications 1 à 9,
dans lequel l'amincissement (14) comprend un renflement dans une surface de l'élément de renforcement respectif (13a, 13b).

11. Ensemble selon l'une quelconque des revendications 1 à 10,
dans lequel l'élément de renforcement respectif (13a, 13b) comprend une pluralité d'amincissements (14).

12. Ensemble selon l'une quelconque des revendications précédentes,
dans lequel l'élément de renforcement respectif (13a, 13b) comprend une bande métallique ou une bande de tôle.

13. Ensemble selon l'une quelconque des revendications précédentes,
dans lequel l'élément de renforcement respectif (13a, 13b) est réalisé en une seule pièce.
